# FASCICULE DE BREVET EUROPEEN

(11) **EP 2 104 952 B1**
(45) Date de publication et mention de la délivrance du brevet: **10.07.2013**
(21) Numéro de dépôt: 07858221.0
(22) Date de dépôt: 28.12.2007
(51) Int. Cl.: H01L 27/11, H01L 21/8244

(54) **PROCEDE DE REALISATION DE TRANSISTORS A DOUBLE-GRILLE ASYMETRIQUES PERMETTANT LA REALISATION DE TRANSISTORS A DOUBLE-GRILLE ASYMETRIQUES ET SYMETRIQUES SUR UN MEME SUBSTRAT**
VERFAHREN ZUR HERSTELLUNG VON ASYMMETRISCHEN DOPPELGATETRANSISTOREN, WODURCH SYMMETRISCHE UND ASYMMETRISCHE DOPPELGATETRANSISTOREN AUF DEMSELBEN SUBSTRAT HERGESTELLT WERDEN KÖNNEN
METHOD FOR PRODUCING ASYMMETRIC DOUBLE-GATE TRANSISTORS, WHEREBY SYMMETRIC AND ASYMMETRIC DOUBLE-GATE TRANSISTORS CAN BE PRODUCED ON THE SAME SUBSTRATE

(30) Priorité: 28.12.2006 FR 0656010
(43) Date de publication de la demande: 30.09.2009
(73) Titulaire: Commissariat à l'Énergie Atomique et aux Énergies Alternatives, 75015 Paris (FR)
(72) Inventeur: VINET, Maud, F-38140 Rives (FR); THOMAS, Olivier, F-38420 Revel (FR); ROZEAU, Olivier, F-38430 Moirans (FR); POIROUX, Thierry, F-38340 Voreppe (FR)
(74) Mandataire: Ilgart, Jean-Christophe
(86) Numéro de dépôt international: PCT/EP2007/064631
(87) Numéro de publication internationale: WO 2008/080981

(56) Documents cités:
- EP-A1- 0 457 434
- WO-A-03/021633
- US-A1- 2005 017 377
- US-A1- 2005 110 079
- KIYOSHI TAKEUCHI ET AL: "A Study of the Threshold Voltage Variation for Ultra-Small Bulk and SOI CMOS" IEEE TRANSACTIONS ON ELECTRON DEVICES, IEEE SERVICE CENTER, PISACATAWAY, NJ, US, vol. 48, no. 9, septembre 2001 (2001-09), XP011017796 ISSN: 0018-9383

## Description

### DOMAINE TECHNIQUE

L'invention se rapporte au domaine des dispositifs microélectronique dotés de transistors à double-grille et concerne un procédé amélioré de réalisation de transistors à double-grille asymétrique.

L'invention concerne également un procédé de réalisation d'un dispositif microélectronique doté d'un ou plusieurs transistors à double-grille symétrique et d'un ou plusieurs transistors à double-grille asymétrique co-intégrés sur un même substrat.

L'invention s'applique notamment au domaine des mémoires à accès aléatoires, telles que les mémoires SRAM (SRAM pour « static random access memory » ou mémoires statiques à accès aléatoires).

### ART ANTÉRIEUR

La réalisation de transistors à double-grille dotés de deux grilles indépendantes qui ont des caractéristiques électriques symétriques ou un comportement identique pour une même polarisation est connue. Par transistors double-grille, on entend que ces transistors comportent une première grille et une deuxième grille indépendantes formées de part et d'autre d'une zone active, la première grille et la deuxième grille étant connectées ou non entre elles.

Les transistors double-grille peuvent être réalisés selon une structure dite « planaire », formée d'une première grille et d'une deuxième grille, agencées de sorte que la première grille, une zone semi-conductrice destinée à former un ou plusieurs canaux, et la deuxième grille, sont superposées sur un substrat.

Les transistors double-grille peuvent être également réalisés selon une structure de type dit « finFET ». Dans ce type de transistor, la double-grille est formée d'une première grille et d'une deuxième grille, agencées de sorte que la première grille, une zone semi-conductrice destinée à former un ou plusieurs canaux, et la deuxième grille, sont juxtaposées sur un substrat.

Il est également connu de réaliser des transistors à double-grille asymétrique. Une double-grille asymétrique est formée de deux grilles distinctes dissymétriques par rapport au plan principal d'une zone semi-conductrice destinée à former un ou plusieurs canaux, de part et d'autre de laquelle ces grilles sont disposées.

Pour réaliser des transistors asymétriques à structure planaire, des procédés de réalisation de type dit « non auto-aligné », c'est-à-dire pour lesquelles chacune des grilles est définie par une lithographie différente, sont apparus.

Le document WO 031021633 décrit un procédé de réalisation d'un transistor à double-grille asymétrique. Le document [ILL05] divulgue un exemple de réalisation de transistor à double-grille asymétrique à l'aide d'un procédé non auto-aligné.

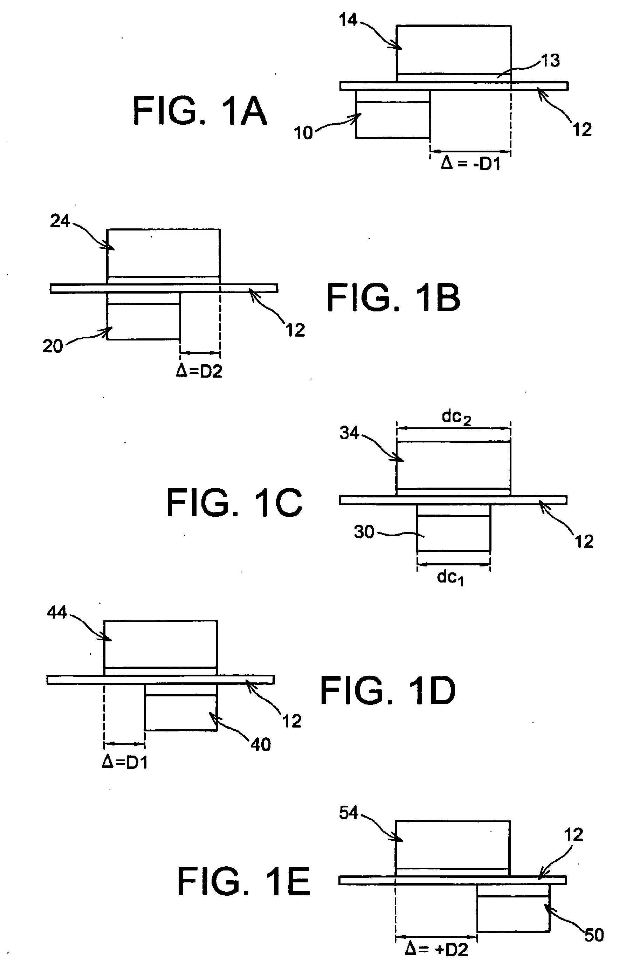

Les figures 1A-1E illustrent différents exemples de réalisation de structure double-grille asymétrique planaire.

Une solution pour réaliser des transistors asymétriques avec une technologie non auto-alignée consiste à former une première grille ou grille arrière intentionnellement décalée par rapport à la deuxième grille ou grille avant, et/ou ayant une dimension critique plus faible que celle de la grille avant.

Sur la figure 1A, un exemple de structure de transistor à double-grille planaire asymétrique est illustré. Cette structure est dotée d'une première grille 10 ou grille arrière, en contact avec une première couche 11 de diélectrique de grille, et d'une deuxième grille 14 formée sur une deuxième couche de diélectrique de grille 13, une zone active semi-conductrice 12 destinée à former un ou plusieurs canaux, étant située entre la première couche diélectrique 11 et la deuxième couche diélectrique 13. La première grille 10 et la deuxième grille 14 sont décalées de sorte qu'une partie de la première grille 10 n'est pas située en regard de la deuxième grille 14 et qu'une partie de la deuxième grille 14 n'est pas située en regard de la première grille 10. Dans cet exemple, le décalage Δ entre les deux grilles 10 et 14 est tel que Δ = D1, avec D1 par exemple de l'ordre de 30 nanomètres.

Un autre exemple de dissymétrie est illustré sur la figure 1B. Sur cette figure, un transistor à double-grille planaire asymétrique est doté d'une première grille 20 formée au-dessous d'une zone active semi-conductrice 12 et en regard d'une deuxième grille 24 de dimension critique inférieure à celle de la première grille, et formée au dessus de ladite zone active semi-conductrice 12. La deuxième grille 24 et la première grille 20 sont décalées de sorte que la deuxième grille 24 est située totalement en regard de la première grille 20 tandis qu'une partie de la deuxième grille 24 est située en regard de la zone active semi-conductrice 12 mais n'est pas située en regard de la deuxième grille 24. Dans cet exemple, le décalage Δ entre les deux grilles 20, 24 est tel que Δ = + D2 avec D2 par exemple de l'ordre de 15 nanomètres.

Sur la figure 1C, un autre exemple de structure de transistor à double-grille planaire asymétrique est donné. Cette structure est dotée d'une première grille 30 ou grille inférieure, de dimension critique dc₁ et d'une deuxième grille 34 ou grille supérieure, de dimension critique dc₂ supérieure à dc₁.

Sur la figure 1D, un autre exemple de structure de transistor à double-grille planaire asymétrique est donné. Cette structure est dotée d'une première grille 40 ou grille inférieure, de dimension critique donnée et d'une deuxième grille 44 ou grille supérieure, de dimension critique supérieure. Le décalage Δ entre les deux grilles est tel que Δ = - D1.

Sur la figure 1E, un autre exemple de structure de transistor à double-grille planaire asymétrique est donné. Cette structure est dotée d'une première grille 50 ou grille inférieure, de dimension critique dc₁ et d'une deuxième grille 54 ou grille supérieure, Le décalage Δ entre les deux grilles étant tel que Δ = - D2.

En ajustant le décalage Δ entre les deux grilles d'une double-grille asymétrique, on peut ajuster le courant de fuite I_{off} du transistor.

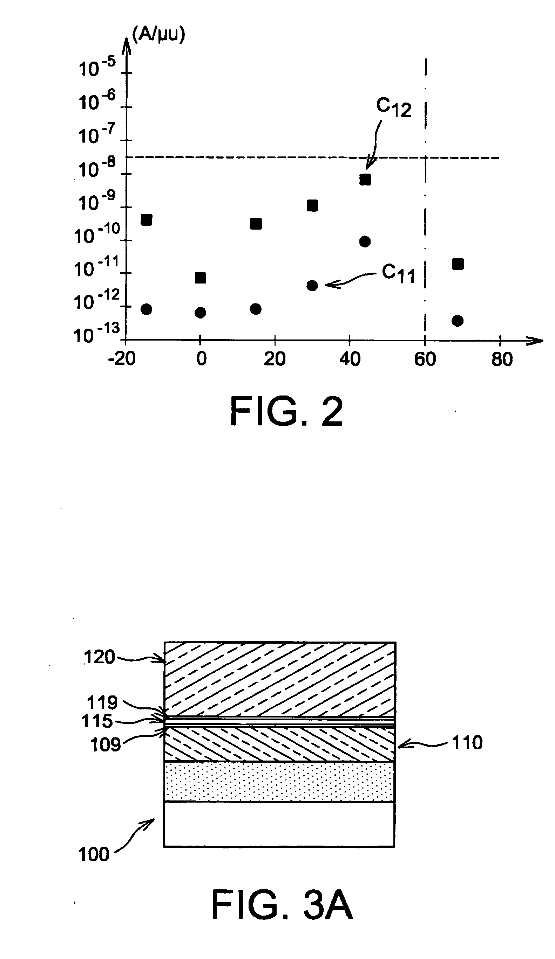

Sur la figure 2, des courbes C₁₁ et C₁₂ sont représentatives respectivement de simulations et de mesures d'un courant de fuite I_{off} d'une structure double-grille asymétrique en fonction du décalage Δ entre ses deux grilles inférieure et supérieure. Les grilles ont chacune une dimension critique de l'ordre de 70 nanomètres tandis que l'épaisseur du canal est de l'ordre de 10 nanomètres.

Avec des procédés qui ne sont pas auto-alignés, il est difficile d'obtenir un décalage Δ précis entre les grilles. Pour certaines applications, un décalage Δ contrôlé et très faible, par exemple de l'ordre de 2 à 5 nanomètres est souhaité.

Pour la mise en oeuvre de transistors double-grille symétriques, le manque de précision des procédés de réalisation « non auto-alignés » pose également problème. Les résultats actuellement obtenus avec de tels procédés montrent qu'il est difficile d'obtenir deux grilles de même longueur et bien alignées. Cela nuit en particulier au fonctionnement dynamique des transistors réalisés à l'aide d'un tel procédé.

Afin de bénéficier des avantages intrinsèques des structures à double-grille planaires, des procédés de réalisation auto-alignés, c'est-à-dire lors desquels les deux grilles sont définies par une même étape de lithographie sont apparus. Un tel type de procédé est présenté par exemple dans le document [DEL01].

Il se pose le problème de trouver un nouveau procédé de réalisation de transistors à double-grille asymétrique.

### EXPOSÉ DE L'INVENTION

L'invention concerne un procédé de réalisation selon la revendication 1.

Par implantation sélective on entend que le premier bloc n'est pas implanté ou moins implanté que le deuxième bloc.

Une telle étape d'implantation permet de réaliser des doubles-grilles asymétriques.

En réalisant le premier bloc et le deuxième bloc avec une dimension critique inférieure à la dimension critique de la deuxième zone isolante et/ou de la première zone isolante, la deuxième zone isolante et/ou de la première zone isolante peut former des moyens de protection du premier bloc vis-à-vis de l'implantation.

La première implantation est réalisée selon un angle prédéterminé non-nul par rapport à une normale au plan principal du substrat passant par la zone semi-conductrice.

Selon une possibilité, ladite implantation peut être réalisée dans des zones du deuxième bloc situées à proximité et/ou en contact de la deuxième zone diélectrique.

Selon une mise en oeuvre particulière, ladite implantation peut être réalisée d'un premier côté de la structure, l'autre côté par rapport à une normale au plan principal du substrat passant par la zone semi-conductrice n'étant pas implanté.

Le procédé peut comprendre après l'étape b) : au moins une étape c) de gravure sélective entre des zones semi-conductrices non-implantées desdits blocs et des zones semi-conductrices implantées du deuxième bloc.

Cela peut permettre de réaliser des doubles-grilles asymétriques de dimensions critiques respectives différentes.

La gravure sélective peut être une gravure sélective, entre des zones semi-conductrices non dopées et des zones semi-conductrices dopées par ladite implantation.

Selon une variante, la gravure sélective peut être une gravure sélective, entre des zones semi-conductrices dopées suivant un type de dopage donné et des zones semi-conductrices dopées par ladite implantation suivant un autre type de dopage différent du type de dopage donné.

Les structures peuvent être des structures dites « planaires » et tel que le premier bloc repose sur le substrat, le premier bloc, la zone semi-conductrice et le deuxième bloc étant superposés au-dessus dudit substrat.

A l'étape b), le deuxième bloc peut être recouvert d'un masque dur, le masque dur ayant une dimension critique supérieure à la dimension critique du deuxième bloc.

De cette manière, le masque dur peut former des moyens de protection de la partie supérieure du deuxième bloc vis-à-vis de l'implantation.

Selon une mise en oeuvre possible de la structure, le premier bloc et/ou le deuxième bloc peuvent être à base d'un matériau semi-conducteur.

Selon une variante, le premier bloc et/ou le deuxième bloc peuvent être formés respectivement d'au moins une couche métallique et d'au moins une couche semi-conductrice empilées.

Le procédé suivant l'invention peut être mis en oeuvre pour réaliser des transistors double-grille asymétriques et symétriques sur un même substrat.

Dans ce cas, à l'étape b), au moins une structure particulière parmi lesdites structures formées à l'étape a) est protégée de l'étape de dopage réalisée à l'étape b), à l'aide d'au moins une couche de protection, par exemple à base de résine ou une couche de masque dur à base d'un matériau diélectrique par exemple tel que du SiO₂ ou du Si₃N₄, ladite structure particulière étant prévue pour former un transistor à double-grille symétrique.

Ensuite, le premier bloc et le deuxième bloc de cette structure particulière peuvent être gravés en même temps que le premier bloc et le deuxième bloc de ladite structure donnée, ladite structure donnée étant prévue pour former un transistor à double-grille asymétrique, tandis que la structure particulière est prévue pour former un transistor à double-grille symétrique.

L'invention concerne également un procédé de réalisation d'une structure de cellule mémoire à accès aléatoire dotée de transistors double-grille asymétriques comprenant un procédé tel que défini précédemment.

L'invention concerne également un procédé de réalisation d'une structure de cellule mémoire à accès aléatoire dotée de transistors double-grille asymétriques et de transistors double-grille symétriques à l'aide d'un procédé tel que défini précédemment.

La mémoire peut être une mémoire statique à accès aléatoire SRAM.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1E, illustrent différents modes de réalisation d'une double-grille planaire asymétrique ;
- la figure 2 donne des exemples de courbes de simulation et de mesure d'un courant de fuite d'une structure double-grille asymétrique en fonction du décalage entre ses deux grilles ;
- les figures 3A-3E, illustrent un exemple de procédé suivant l'invention, de réalisation d'une double-grille planaire asymétrique ;
- les figures 4A-4B, illustrent une variante de l'exemple de procédé suivant l'invention, de réalisation d'une double-grille planaire asymétrique :
- les figures 5A-5B, illustrent un exemple de procédé de réalisation de structure double-grille asymétrique et de structure double-grille symétrique sur un même substrat ;
- les figures 6A-6B, illustrent un autre exemple de procédé de réalisation de structure double-grille asymétrique et de structure double-grille symétrique sur un même substrat ;
- la figure 7 illustre un exemple de cellule mémoire 4T, dotée de 4 transistors à double-grille asymétrique susceptibles d'être mis en oeuvre à l'aide d'un procédé suivant l'invention ;
- la figure 8 représente une portion d'un exemple de matrice mémoire dotée de cellules du type de celle de la figure 7 ;
- la figure 9 illustre un autre exemple de cellule mémoire 4T, réalisée dans une technologie complémentaire de celle de la cellule de la figure 7 ;
- la figure 10 illustre un autre exemple de cellule mémoire 4T, dotée de 2 transistors à double-grille asymétrique et de 2 transistors à double-grille asymétrique co-intégrés sur un même substrat ;
- la figure 11A, illustre un exemple d'évolution du courant de canal d'un transistor double-grille, en fonction de la polarisation de ses deux grilles ;
- la figure 11B, illustre un exemple d'évolution du courant de canal d'un transistor double-grille asymétrique, en fonction de la polarisation de ses deux grilles ;
- la figure 12 illustre un autre exemple de cellule mémoire 4T, réalisée dans une technologie complémentaire de celle de la cellule de la figure 11 ;
- la figure 13 illustre un exemple de cellule mémoire 8T, dotée de 8 transistors à double-grille dont quatre transistors à double-grille asymétrique et quatre autres transistors à double-grille symétrique co-intégrés sur un même substrat.

### EXPOSÉ DÉTAILLÉ DE MODES DE RÉALISATION PARTICULIERS

Un exemple détaillé de procédé de réalisation d'une structure de double-grille planaire asymétrique, formée de deux grilles de cotes ou dimensions critiques différentes, va à présent être donné en liaison avec les figures 3A à 3E.

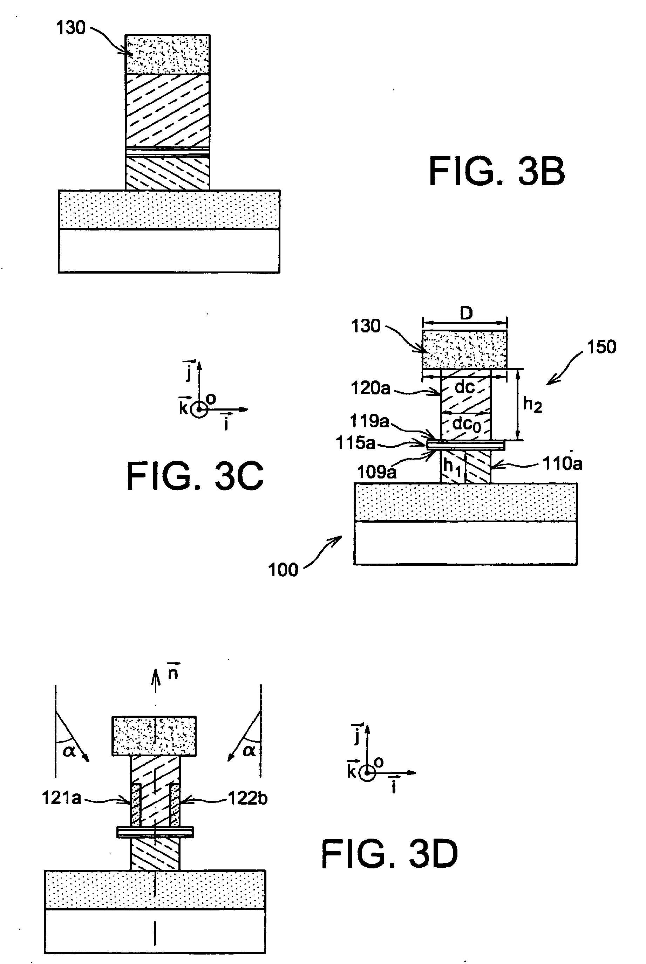

On réalise tout d'abord sur un substrat 100, une structure 150 formée d'un empilement tel qu'illustré sur la figure 3C, comprenant un premier bloc 110a de grille, une première zone 109a de diélectrique de grille reposant sur le premier bloc 110a, une zone semi-conductrice 115a reposant sur la première zone diélectrique 109a, une deuxième zone 119a de diélectrique de grille reposant sur la zone semi-conductrice 115a, un deuxième bloc 120a de grille reposant sur la deuxième zone 119a diélectrique. Le deuxième bloc 120a de grille peut être à base d'un matériau semi-conducteur tel que par exemple du polysilicium éventuellement dopé, tandis que le premier bloc 110a de grille peut être également à base d'un matériau semi-conducteur tel que par exemple du polysilicium éventuellement dopé. Les zones diélectriques 109a et 119a et la zone semi-conductrice 120a sont réalisées avec une côte ou une dimension critique dc supérieure à celles dc₀ du premier bloc 110a de grille et du deuxième bloc 120a de grille (les dimensions critiques dc₀ et dc étant des dimensions définies dans une direction parallèle au vecteur i̅ du repère orthogonal [O; i̅; j̅; k̅] sur la figure 3C). Le deuxième bloc 120a de grille peut être éventuellement surmonté d'un masque dur 130 à base de matériau diélectrique, par exemple tel que du SiO₂ ou du Si₃N₄.

Une telle structure 150 a été réalisée à partir d'un empilement de couches minces réalisé sur un substrat 100, par exemple un substrat de type semi-conducteur sur isolant, ledit empilement étant formé d'au moins une première couche 110 de matériau de grille, d'au moins une couche 109 de matériau diélectrique sur la couche 110 de matériau de grille, d'au moins un couche semi-conductrice 115 sur la couche diélectrique 109, et d'au moins une deuxième couche 120 de matériau de grille sur la couche semi-conductrice 115. Les couches 110 et 120 de matériau de grille peuvent être formées par exemple à base de polysilicium. La première couche 110 de matériau de grille peut avoir une épaisseur comprise par exemple entre 10 nanomètres et 100 nanomètres, tandis que la deuxième couche 120 de matériau de grille peut être réalisée avec une épaisseur supérieure, comprise par exemple entre 5 nanomètres et 50 nanomètres (figure 3A).

Ensuite, pour réaliser la structure 150, une gravure de l'empilement, par exemple anisotrope, peut avoir été effectuée à travers le masque dur 130, de manière à former le premier bloc de grille, la première zone diélectrique, la zone semi-conductrice, la deuxième zone diélectrique, le deuxième bloc de grille. La gravure de l'empilement peut être par exemple une gravure plasma anisotrope à base de HBr et d'oxygène (figure 3B).

On peut ensuite avoir effectué une deuxième gravure, sélective vis-à-vis de la zone semi-conductrice et des zones diélectriques, de manière à réduire latéralement le premier bloc 110a et le deuxième bloc 120a de grille. La deuxième gravure peut être par exemple une gravure plasma isotrope à base de CF₄ (figure 3C).

Après avoir obtenu la structure 150, on réalise (figure 3D) un dopage du deuxième bloc 120a à l'aide d'au moins une première implantation, sélective vis-à-vis du premier bloc 110a. Par implantation sélective, on entend qu'on réalise une implantation du deuxième bloc 120a, sans implanter le premier bloc 110a ou en implantant moins le premier bloc 110a. Dans cet exemple, l'implantation est réalisée de sorte que le premier bloc 110a n'est pas implanté au voisinage de l'interface avec la première zone diélectrique 109a ou dans une zone située contre la première zone diélectrique 109a. Les zones diélectriques 109a et 119a peuvent permettre de protéger au moins une partie du premier bloc 110a lors de l'étape d'implantation.

L'implantation sélective peut être réalisée de manière à obtenir des zones du deuxième bloc 120a implantées 121a et 122a, notamment dans des régions du deuxième bloc 120a situées au niveau des flancs de ce dernier et contre la deuxième zone diélectrique 119a, tandis que le premier bloc n'est pas implanté ou n'est pas implanté au moins dans la zone du premier bloc 110a située contre la première zone diélectrique 120a.

L'implantation est inclinée selon un angle α prédéterminé par rapport à une normale au plan principal du substrat 100 (le plan principal du substrat étant défini sur la figure 3D comme un plan passant par le substrat et parallèle au plan [O; i̅; k̅]). L'angle α d'implantation peut être par exemple compris entre 7° et 45°. La dimension critique dc des zones diélectriques 109a, 119a, les hauteurs h₁ et h₂ respectives du premier bloc 110a de grille et du deuxième bloc de grille 120a, ainsi que l'angle α d'implantation peuvent être prévus de manière à réaliser un dopage du deuxième bloc 120a de grille, de préférence sans doper le premier bloc 110a. Pour mettre en oeuvre cette implantation sélective, la structure 150 peut être réalisée de sorte que le premier bloc 110a et le deuxième bloc 120a ont une dimension critique dc inférieure à celle notée dc₀ des zones 109 et 119 de diélectrique de grille et de la zone semi-conductrice 115. Les dimensions critiques dc et dc₀ peuvent être telles que dc₀-dc = l₂ avec l₂ par exemple compris entre 5 nanomètres et 25 nanomètres. Les zones diélectriques 109a, 119a ayant une dimension critique supérieure à celle des blocs 110a et 120a, les zones 119a et 109a sont susceptibles de former des moyens de protection du premier bloc lors de l'implantation inclinée, de sorte que ce premier bloc n'est pas implanté ou n'est pas implanté au voisinage de l'interface avec le premier diélectrique 109a. Les zones diélectriques 109a, 119a forment ainsi un masque à implantation pour le premier bloc 110a. Pour mettre en oeuvre cette implantation sélective, les blocs 110a et 120a peuvent être prévus de sorte que le deuxième bloc 120a, a une hauteur h₂ supérieure à la hauteur h₁ du premier bloc 110a de grille (les hauteurs h₁ et h₂ étant des dimensions définies dans une direction parallèle au vecteur *j̅* d'un repère orthogonal [O; *i̅; j̅; k̅*] sur la figure 3C). La hauteur h₂ du deuxième bloc 120a peut être prévue telle que h₂ inférieure ou égale à (dc-dco)/tan α. La hauteur h₂ du deuxième bloc 120a peut être comprise par exemple entre 5 nanomètres et 50 nanomètres. La hauteur h₁ du premier bloc 110a peut quant à elle être comprise par exemple entre 10 nanomètres et 100 nanomètres. La dimension critique D du masque dur peut être prévue supérieure à celle du deuxième bloc 120a, de manière à protéger la partie supérieure de ce dernier lors de l'implantation. La dimension critique D du masque dur peut être telle que D-dc = l₁, avec l₁ par exemple inférieur à 30 nanomètres. Dans cet exemple, l'implantation est une implantation localisée du deuxième bloc 120a, réalisée de chaque côté de la structure 150, dans des zones semi-conductrices localisées situées au niveau des flancs de ce deuxième bloc 120a et à proximité et/ou en contact avec la zone de diélectrique de grille 109.

Le dopage par implantation est un dopage d'un type prédéterminé ou réalisé avec une espèce prédéterminée. Dans le cas où les blocs 110a et 120a sont à base de polysilicium, on peut par exemple réaliser un dopage de type N avec de l'arsenic à une dose par exemple de 3¹⁵ atomes.cm⁻² et une énergie choisie en fonction de la différence de cote ou de dimension critique que l'on souhaite obtenir entre les deux grilles. Pour obtenir une différence contrôlée de cote de l'ordre de 3 nanomètres, de part et d'autre de la grille, on pourrait par exemple implanter à 3 keV et avec de l'arsenic ou du Phosphore ou de l'Antimoine, un bloc semi-conducteur 120a, par exemple formé de polysilicium déjà dopé P avec un dopant tel que du Bore, à un niveau moyen de 10²⁰ atomes.cm⁻³. Selon une variante, l'implantation peut être une implantation de polysilicium réalisée avec du Germanium.

Les blocs 110a et 120a peuvent être déjà dopés avant l'étape d'implantation sélective, et avoir été dopés par exemple au moment du dépôt des couches semi-conductrices 110 et 120. Dans ce cas, l'implantation sélective du deuxième bloc 120a permet de modifier le dopage du deuxième bloc 120a, notamment dans des régions situées au niveau des flancs de ce dernier et contre la deuxième zone diélectrique 119a, tandis qu'au moins dans une zone située contre la première zone diélectrique 109a, le dopage du premier bloc 120a n'est pas modifié suite à ladite implantation sélective.

Ensuite, on réalise une gravure sélective entre des zones semi-conductrices qui ont été implantées et des zones semi-conductrices qui n'ont pas été implantées lors de l'étape précédemment décrite.

Selon un exemple, la gravure sélective peut être un retrait sélectif d'un matériau semi-conducteur implanté N dans le cas où les zones semi-conductrices 121a et 122a ont été implantées N, par rapport à des zones non-implantées mais dopées P.

Un exemple de procédé de gravure plasma qui permet de conduire à une sélectivité entre un matériau semi-conducteur implanté suivant un dopage de type N et un matériau dopé P est donné dans le tableau suivant :

| | **C12** | **SF6** | **Ps (W)** | **Pb (W)** | **P(mT)** | **t(s)** |
|---|---|---|---|---|---|---|
| BT | 60 | - | 750 | 150 | 30 | 5 |
| ME | 150 | - | 1000 | 0 | 4 | 15 |
| OE | 150 | - | 1000 | 0 | 70 | 30 |

Dans ce tableau BT, ME, OE, signifient respectivement : perçage (BT pour « Break Through » selon la terminologie anglo-saxonne), gravure principale (ME pour « Main Etch » selon la terminologie anglo-saxonne), surgravure (OE pour « Over Etch » selon la terminologie anglo-saxonne).

Avec un tel procédé, les zones dopées N, par exemple les zones semi-conductrices 121a et 122a du premier bloc seront gravées tandis que la zone dopée P ne sera pas gravée.

Selon un autre exemple, la gravure sélective peut être un retrait sélectif d'un matériau semi-conducteur implanté P ou P+ dans le cas où les zones semi-conductrices 121a et 122a ont été implantées P ou P+, par rapport à des zones non-implantées et dopées N.

Selon un autre exemple, la gravure sélective peut être un retrait sélectif d'un matériau semi-conducteur implanté N+ dans le cas où les zones semi-conductrices 121a et 122a ont été implantées N+, par rapport à des zones non-implantées mais dopées P.

Dans le cas par exemple où les zones semi-conductrices 121a et 122a sont à base de polysilicium et ont été implantées P+, une gravure sélective avec du HNA (HF/HNO₃/CH₃COOH) peut être effectuée.

Dans le cas par exemple où les zones semi-conductrices 121a et 122a sont à base de polysilicium et ont été implantées N+, une gravure sélective avec du HNA (HF/HNO₃/CH₃COOH) peut également être effectuée.

Selon un autre exemple, la gravure sélective peut être un retrait sélectif d'un matériau semi-conducteur implanté dans le cas où les zones semi-conductrices 121a et 122a ont été dopées par implantation, par rapport à des zones semi-conductrices qui n'ont pas été implantées et qui ne sont pas dopées. Dans le cas par exemple où les zones semi-conductrices 121a et 122a sont à base de polysilicium et ont été implantées selon un dopage N, une gravure sélective avec du TMAH (tétra-méthyl ammonium hydroxyde), peut être effectuée. Dans ce cas, les zones non-dopées sont gravées plus rapidement que les zones 121a, 122a implantées.

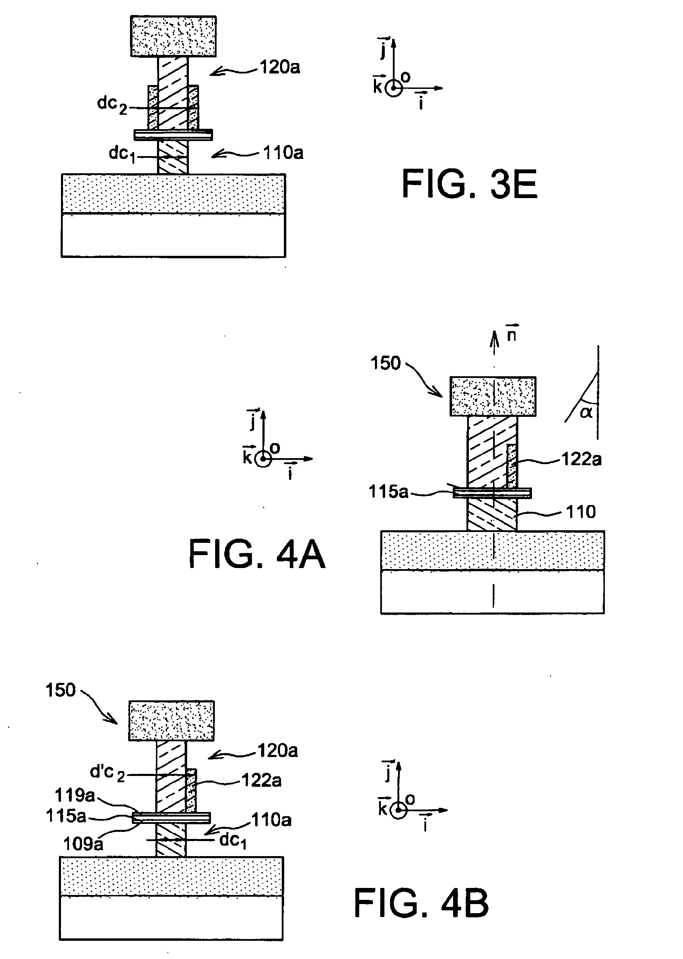

Sur la figure 3E, un tel exemple est illustré. Une fois la gravure sélective réalisée, le premier bloc 110a destiné à former une première grille, a une dimension critique dc₁, tandis que le deuxième bloc 120b destiné à former une deuxième grille, a une dimension critique d_{c2} supérieure à d_{c1}, les zones semi-conductrices 121a, 122a implantées ayant été moins gravées que les zones semi-conductrices non implantées.

Dans le cas où le premier bloc et le deuxième bloc sont à base de polysilicium, l'implantation réalisée précédemment peut être une implantation de germanium dans le polysilicium, de manière à utiliser ensuite un procédé de gravure sélective du polysilicium implanté avec du Germanium, par rapport au polysilicium, par exemple à l'aide d'une gravure plasma isotrope à base de CF₄.

Des implantations pour définir les extensions de zone de source et de drain peuvent avoir été effectuées avant l'étape d'implantation sélective.

Selon une variante de l'exemple de procédé précédemment donné, lors de l'étape d'implantation sélective décrite précédemment, on peut effectuer l'implantation que d'un seul côté de la structure 150.

Sur la figure 4A, une zone semi-conductrice 122a située au niveau d'un flanc du deuxième bloc 120, contre le diélectrique 119 de grille est implantée tandis que de l'autre côté, par rapport à une normale au plan principal du substrat 100 passant par la structure 150, le deuxième bloc n'est pas implanté. La structure 150 est réalisée de sorte que le premier bloc et le deuxième bloc ont une dimension critique inférieure à la dimension critique de la deuxième zone isolante et/ou de la première zone isolante.

La structure de grille une fois la gravure sélective réalisée, le premier bloc 110a destiné à former une première grille, a une dimension critique dc₁, tandis que le deuxième bloc 120b destiné à former une deuxième grille de dimension critique d'c₂ supérieure à dc₁ (figure 4B).

Une autre variante de l'un où l'autre des procédés précédemment décrits, prévoit la réalisation d'une structure double-grille asymétrique dotée de deux grilles ayant des compositions différentes et prévues pour avoir des travaux de sortie respectifs différents.

Dans ce cas, les blocs 110a et 120a peuvent être formées par exemple d'un bicouche. Le premier bloc 110a peut être formé par exemple d'une couche métallique par exemple à base de TiN ou de TaN en contact avec la première zone diélectrique 109 et d'une couche de matériau semi-conducteur, par exemple à base de polysilicium, sur laquelle repose la couche métallique. Le deuxième bloc 120a peut être également formé d'un bicouche, comprenant une couche métallique par exemple à base de TiN ou de TaN en contact avec la deuxième zone diélectrique 119 et d'une couche de matériau semi-conducteur, par exemple à base de polysilicium, reposant sur la couche métallique. La structure 150 est réalisée de sorte que le premier bloc et le deuxième bloc ont une dimension critique inférieure à la dimension critique de la deuxième zone isolante et/ou de la première zone isolante.

Ensuite, lors de l'implantation sélective du deuxième bloc 120a, on implante la couche semi-conductrice du bi-couche. On peut déplacer le travail de sortie du bicouche couche semi-conductrice polysilicium/couche métallique vers la couche semi-conductrice à base de polysilicium. L'énergie de l'implantation et le recuit d'implantation sont ajustés pour que l'implantation atteigne le centre de la grille afin que le travail de sortie soit ajusté sur toute la surface de la grille. On peut ainsi réaliser des transistors au fonctionnement asymétrique, par exemple avec une longueur de grille de l'ordre de 20 nm, et une tension de seuil pour la première grille Vth1 ajustée par exemple à 0,1 Volts, et une tension de seuil pour la deuxième grille Vth2 ajustée par exemple à 0,3 Volts soit une différence de travail de sortie par exemple de l'ordre de 0,4 Volts entre les deux grilles.

L'un ou l'autre des procédés précédemment décrits peut être mis en oeuvre pour la réalisation ou co-intégration sur un même support ou un même substrat 100 de transistors à double-grille planaire asymétrique et de transistors planaires symétriques.

Pour cela, on réalise sur un substrat tel que le substrat 100, plusieurs structures, par exemple une première structure 250, et une deuxième structure 260 du type de la structure 150 précédemment décrite. Ensuite, préalablement à l'étape d'implantation sélective, on forme des moyens de protection vis-à-vis d'un faisceau ionique d'implantation pour la deuxième structure 260. Ces moyens de protection peuvent être formés d'au moins une couche 270 définie par exemple par photolithographie et recouvrant la deuxième structure 260. La couche 270 de protection peut être par exemple une couche à base de résine ou un masque dur, par exemple à base de Si₃N₄ ou de SiO₂. La couche de protection 270 comporte au moins une ouverture dévoilant la première structure 250.

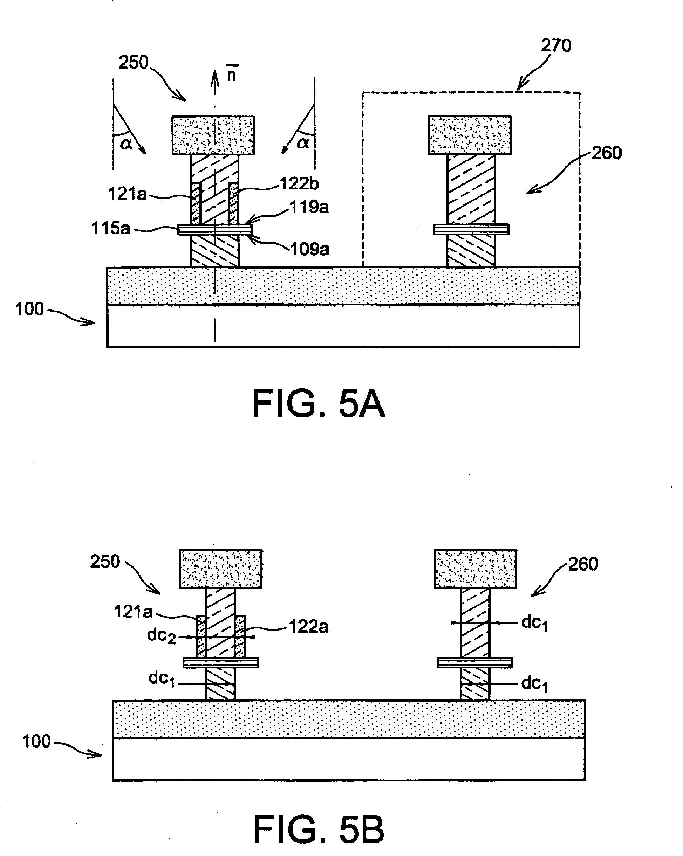

Ensuite (figure 5A), on réalise une implantation sélective du deuxième bloc de grille de la première structure 250, par exemple de la manière décrite précédemment en liaison avec la figure 3D. Lors de cette implantation, la couche 270 protège la deuxième structure 260 du faisceau de particules.

Puis, on retire la couche de protection 270, par exemple à l'aide d'un par plasma O₂ suivi d'une gravure chimique à base d'un mélange acide sulfurique, eau oxygénée, lorsque cette couche de protection est à base de résine.

On réalise ensuite l'étape de gravure des blocs de grilles de la première structure 250 et de la deuxième structure 260. Cette gravure est une gravure sélective des zones semi-conductrices 121a, 122a implantées vis-à-vis de zones semi-conductrices qui n'ont pas été implantées.

Sur la figure 5B, la première structure 250 et la deuxième structure 260 reposant sur le substrat 100 sont représentées, une fois la gravure réalisée. La première structure 250 comporte un premier bloc 110a de grille de dimension critique dc₁, et un deuxième bloc 120a destiné à former une deuxième grille de dimension critique dc₂, les zones semi-conductrices 121a, 122a implantées ayant été moins gravées que les zones semi-conductrices non implantées. La deuxième structure 260 une fois la gravure sélective réalisée, comporte un premier bloc 210a destiné à former une première grille ayant une dimension critique dc₁, tandis que le deuxième bloc 220b destiné à former une deuxième grille ayant une dimension critique dc₁, identique à celle du premier bloc. La première structure 250 est prévue pour un transistor à double-grille asymétrique tandis que la deuxième structure 260, réalisée sur le même substrat 100 que la première, est prévue pour un transistor double-grille symétrique. Des étapes de réalisation d'espaceurs, de formation de régions de sources et de drain, de réalisation de contacts peuvent être ensuite effectuées pour compléter la formation des transistors à double grille symétrique et à double grille asymétrique.

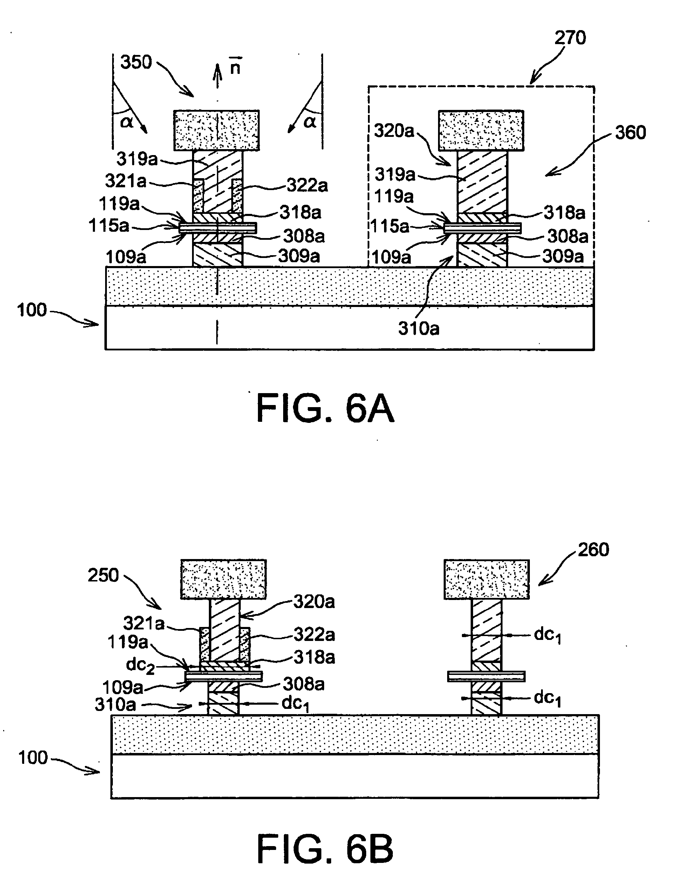

Une variante du procédé précédemment décrit en liaison avec les figures 5A-5B, est donnée en liaison avec les figures 6A-6B. Pour cette variante, on réalise sur le substrat 100, une première structure 350 et une deuxième structure 360, du type des structures 250, 260 précédemment décrites, mais qui comportent, à la place des blocs 110a et 120a semi-conducteurs, des blocs 310a, 320a formés respectivement d'un bicouche.

Le premier bloc 310a peut être formé par exemple d'une couche métallique 308a par exemple à base de TiN ou de TaN en contact avec la première zone diélectrique 109 et d'une couche de matériau semi-conducteur 309a, par exemple à base de polysilicium, sur laquelle repose la couche métallique 308a. Le deuxième bloc 320a peut être également formé par un bicouche, comprenant une couche métallique 318a, par exemple à base de TiN ou de TaN en contact avec la deuxième zone diélectrique 119a et d'une couche de matériau semi-conducteur 319a, par exemple à base de polysilicium, reposant sur la couche métallique 318a.

On effectue (figure 6A), comme pour le procédé précédemment décrit en liaison avec la figure 5A, une implantation sélective du deuxième bloc 320a de la première structure 350, et en particulier de manière à réaliser des zones semi-conductrices 321a et 322a fortement dopées dans la couche de matériau semi-conducteur 309a de la première structure 350. Lors de cette implantation, la deuxième structure 360 est quant à elle protégée par une couche de protection 270, par exemple à base de résine (figure 6A).

Puis, après avoir retiré la couche de protection 270, on effectue une gravure des couches semi-conductrices 309a et 319a du bicouche, sélective vis-à-vis des zones semi-conductrices dopées 321a et 322a de la première structure 350. Cette gravure peut être isotrope et réalisée par exemple à l'aide d'un plasma à base de CF₄.

Puis, les couches métalliques 308a et 318a sont gravées par exemple par gravure chimique à base de HCl et de H₂O₂. Lors de cette étape, les parties des couches 309a et 319a en polysilicium servent de masque à la gravure chimique (figure 6B).

Sur la figure 6B, la première structure 350 et la deuxième structure 360 reposant sur le substrat 100 sont représentées, une fois la gravure réalisée. La première structure 350 comporte un premier bloc 310a ayant une surface de contact donnée avec la première zone diélectrique 109a, tandis que ledit deuxième bloc 320a, a une surface de contact avec la deuxième zone diélectrique 119a supérieure à ladite surface donnée. Dans la première structure 350, la couche métallique 318a du deuxième bloc 320a située en contact avec la deuxième zone diélectrique 119a, a une dimension critique dc2, tandis que et la couche métallique 308a du premier bloc 310a située en contact avec la première zone diélectrique 109a, a une dimension critique dc1, inférieure à dc2.

La deuxième structure 360 une fois la gravure sélective réalisée, comporte un premier bloc destiné à former une première grille ayant une dimension critique dc₁, tandis que le deuxième bloc 320a destiné à former une deuxième grille ayant une dimension critique dc₁, identique à celle du premier bloc. La première structure 350 est prévue pour un transistor à double-grille asymétrique tandis que la deuxième structure 360, réalisée sur le même substrat 100 que la première, est prévue pour un transistor double-grille symétrique.

Un procédé tel que décrit précédemment en liaison avec les figures 3A-3E peut être utilisé pour mettre en oeuvre une cellule mémoire à accès aléatoire dotée de transistors à double-grille asymétriques. A l'aide d'un tel procédé, une cellule dotée uniquement de transistors à double-grille asymétriques peut être réalisée.

Selon une autre possibilité, une cellule dotée de transistors à double-grille asymétriques et de transistors à double-grille symétrique co-intégrés sur un même support peut être réalisée, par exemple à l'aide d'un procédé tel que décrit précédemment en liaison avec les figures 5A-5B.

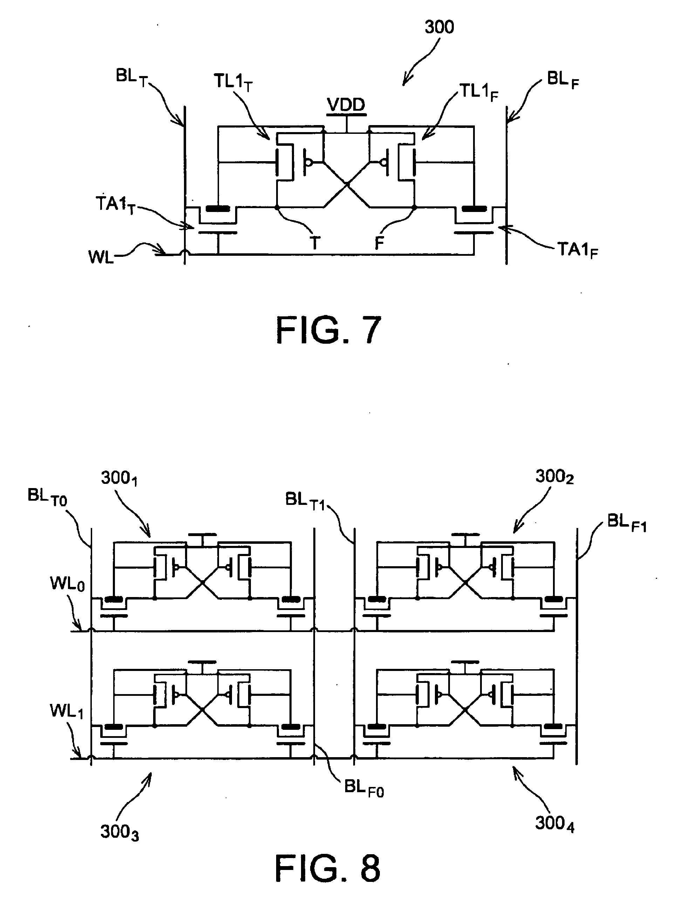

Un exemple de cellule mémoire 300 à accès aléatoire dotée de transistors à double-grille asymétrique mis en oeuvre à l'aide d'un procédé par exemple tel que décrit précédemment en liaison avec les figures 3A-3E, est illustré sur la figure 7.

Cette cellule mémoire 300 est une cellule de mémoire statique SRAM de type 4T, dotée de 4 transistors à double-grille, par exemple réalisés en technologie MOS. La cellule 300 comprend une première pluralité de transistors formant un premier inverseur et un deuxième inverseur, connectés selon une configuration de bascule ou communément appelée « flip-flop ». La première pluralité de transistors peut être formée d'un premier transistor de charge TL1_{T} à double-grille asymétrique, ainsi que d'un deuxième transistor de charge TL1_{F} à double grille asymétrique. Les transistors de charge TL1_{T} et TL1_{F}, peuvent être réalisés dans un premier type de technologie MOS donnée, par exemple une technologie de type PMOS. Les deux grilles du premier transistor de charge TL1_{T} sont connectées l'une à l'autre, tandis que les deux grilles du deuxième transistor de charge TL1_{F} sont également connectées ensemble. La double-grille du deuxième transistor de charge TL1_{F} est également connectée à un premier noeud de stockage T de la première cellule 300, tandis que la double-grille du premier transistor de charge TL1_{T} est également connectée à un deuxième noeud de stockage F de la première cellule 300. Les sources des transistors de charge TL1_{T}, TL1_{F}, peuvent quant à elles, être reliées entre elles et à un potentiel d'alimentation VDD, tandis que le drain du premier transistor de charge TL1_{T} peut être relié au premier noeud T et que le drain du deuxième transistor de charge TL1_{F} est relié au deuxième noeud F. Les transistors de charge TL1_{T} et TL1_{F} sont prévus pour maintenir une charge nécessaire à l'établissement d'un niveau logique donné par exemple un niveau '1', correspondant par exemple à un potentiel égal au potentiel d'alimentation VDD, sur l'un ou l'autre des noeuds T ou F, en fonction de la valeur logique mémorisée dans la cellule 300. La première cellule 300 est également dotée d'un premier transistor d'accès TA1_{T} à double-grille asymétrique et d'un deuxième transistor d'accès TA1_{F} à double-grille asymétrique. Les transistors d'accès TA1_{T}, TA1_{F} peuvent être par exemple de type NMOS. Le premier transistor d'accès TA1_{T} et le deuxième transistor d'accès TA1_{F} comportent chacun une première grille reliée à une première ligne de mot WL. La seconde grille du premier transistor d'accès TA1_{T} est reliée au premier noeud de stockage T, tandis que la seconde grille du deuxième transistor d'accès TA1_{F} est reliée au deuxième noeud de stockage F. La source du premier transistor d'accès TA1_{T} est reliée à une première ligne de bit BL_{T}, tandis que la source du deuxième transistor d'accès TA1_{F} est reliée à une deuxième ligne de bit BL_{F}. Le drain du premier transistor d'accès TA1_{T} est quant à lui relié au premier noeud de stockage T, tandis que le drain du deuxième transistor d'accès TA1_{F} est relié au deuxième noeud de stockage F. Les transistors d'accès TA1_{T}, TA1_{F}, sont agencés de manière à permettre d'accéder aux noeuds de stockage T et F, lors d'une phase de lecture ou d'écriture de la cellule 300, et à bloquer l'accès à la cellule 300, lorsque la cellule 300 est dans un mode de rétention d'information. Une telle cellule 300 permet d'obtenir une marge au bruit statique ainsi qu'un compromis entre la stabilité en rétention et la stabilité en lecture améliorés. Dans cet exemple, un maintien de l'information stockée en rétention sans faire appel à des moyens de rafraîchissement est également réalisé. La ligne de mot WL, est commandée en fonction du mode dans lequel on souhaite placer la cellule 300.

Un exemple de fonctionnement d'une telle cellule 300 est le suivant :

En mode de rétention, les lignes de bit BL_{T}, BL_{F} sont reliées à un potentiel VSS tandis que la ligne de mot WL est également maintenue au potentiel VSS afin de stabiliser une donnée mémorisée. Les transistors d'accès TA1_{T} et TA1_{F} sont quant à eux dans un état bloqué. Dans le cas où le premier noeud T est à un niveau logique haut et le deuxième noeud F à un niveau bas, le deuxième transistor de charge TL1_{F} est également bloqué, seul le premier transistor de charge TL1_{T} étant conducteur. Pour garder le potentiel du deuxième noeud F proche de VSS, le courant qui traverse le deuxième transistor d'accès TA1_{F} doit être supérieur à la somme du courant qui traverse le deuxième transistor de charge TL1_{F} et du courant de grille issu du premier transistor de charge TL1_{T}. La connexion de la seconde grille du deuxième transistor d'accès TA1_{F} au premier noeud de stockage T, mis à VDD, permet d'augmenter son courant de fuite par exemple de 2 à 3 décades et ainsi de garantir une bonne stabilité en rétention. La mise en oeuvre de transistors d'architecture double-grille asymétrique permet de réaliser cette condition dans la mesure où, compte tenu des conditions de polarisation, le deuxième transistor d'accès TA1_{F} présente une tension de seuil inférieure à celle du deuxième transistor de charge TL1_{F}.

En mode lecture, les lignes de bit sont initialement chargées ou préchargées à un potentiel VSS. Ensuite, la ligne de mot est polarisée à un potentiel VDD prévu de manière à permettre un accès aux noeuds de stockage T, F. La stabilité de la cellule 300 en mode lecture dépend de la relation entre les courants de conduction des transistors TL1_{T} et TA1_{T}. Pour obtenir une marge au bruit maximale, le courant de conduction, qui traverse le premier transistor d'accès TA1_{T} est prévu inférieur au courant de conduction du premier transistor de charge TL1_{T}. La connexion de la seconde grille du premier transistor d'accès TA1_{T} au noeud de stockage F, de tension nulle, permet de limiter le courant à l'état passant du premier transistor d'accès TA1_{T} et ainsi de garantir une bonne stabilité de la cellule 300 en lecture. La mise en oeuvre de transistors d'architecture double-grille permet de réaliser cette condition, puisque compte tenu des conditions de polarisation en mode lecture, le premier transistor d'accès TA1_{T} sera doté d'un canal, tandis que le premier transistor de charge TL1_{T} sera doté de deux canaux.

En mode écriture, pour écrire par exemple une valeur logique '0' sur le premier noeud T de sorte que T = 0, et F = 1, la deuxième ligne de bit BL_{F} est initialement chargée ou préchargée à un potentiel VDD tandis que la première ligne de bit BLT est maintenue à un potentiel VSS. Ensuite, la ligne de mot WL est polarisée au potentiel VDD pour activer les transistors d'accès TA1_{T} et TA1_{F} afin de connecter les noeuds de stockage aux lignes de bit.

La cellule mémoire 300 qui vient d'être décrite peut être intégrée dans une matrice mémoire, comme cela est illustré sur la figure 8. Sur cette figure, 4 cellules 300₁, 300₂, 300₃, 300₄, parmi N cellules (avec N>0) du type de la cellule 300, d'une matrice mémoire sont représentées. La matrice mémoire est formée de p colonnes, chaque colonne comprenant m cellules du type de la cellule 300. Dans cet exemple, chacune des colonnes de la matrice comporte deux lignes de bit BLT₀, BLF₀, BLT₁, BLF₁,..., et est contrôlée par un décodeur de colonne. Les m*p cellules mémoires sont commandées par m lignes de mot WL₀, WL₁, ...

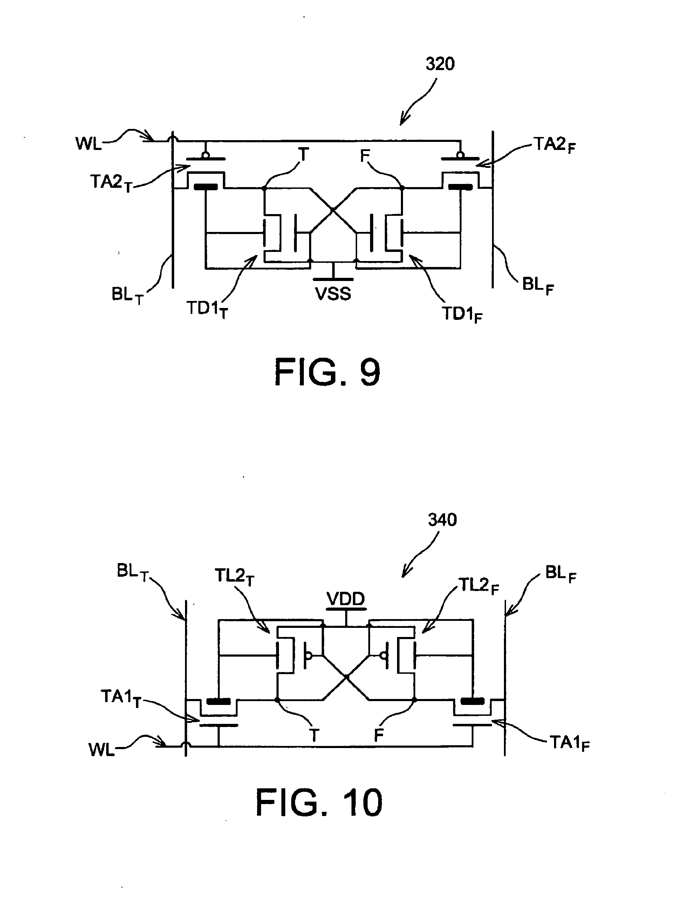

Sur la figure 9, un deuxième exemple de cellule 320 à quatre transistors, complémentaire de la première cellule 300 décrite précédemment est donné. Une telle cellule 320 peut également être réalisée à l'aide d'un procédé suivant l'invention. Dans cet exemple, les transistors de charge sont remplacés par des transistors de conduction TD1T, TD1F par exemple de type NMOS à double-grille asymétrique. Les transistors de conduction TD1T, TD1F sont connectés à VSS. La cellule 320 est également dotée de transistors d'accès TA2_{T}, TA2_{F} réalisés dans une technologie complémentaire de celle des transistors d'accès de la première cellule 300, et peuvent être par exemple de type PMOS.

Selon une variante de mise en oeuvre, dans un cas où l'on souhaite privilégier une stabilité de la cellule en mode lecture, un dispositif de rafraîchissement des données mémorisées peut être associé à la cellule. Le comportement de la cellule est alors dynamique.

Pour améliorer la stabilité de la cellule en mode lecture, sans détériorer la stabilité en rétention, on peut réduire le potentiel de la ligne de mot WL activée en lecture.

Pour améliorer la stabilité globale de la cellule mémoire, il est également possible de co-intégrer des transistors asymétriques et symétriques à l'aide d'un procédé par exemple du type de celui décrit précédemment en liaison avec les figures 5A-5B.

Un troisième exemple de cellule 340 SRAM à 4 transistors, mise en oeuvre à l'aide d'un procédé suivant l'invention, est illustré sur la figure 10. Cette troisième cellule 340, diffère de la première cellule 300, en ce qu'elle comprend un premier transistor de charge TL2_{T} à double-grille symétrique, ainsi qu'un deuxième transistor de charge TL2_{F} également à double-grille symétrique. Des transistors sont ainsi à double-grille symétrique et à double-grille asymétrique sont ainsi co-intégrés dans une même cellule mémoire. Cette amélioration permet d'augmenter un rapport entre courant à l'état passant et courant à l'état bloqué I_{ON}/I_{OFF} des transistors de charge. En mode rétention, la quantité de charge à évacuer dans la ligne de bit BL_{T} à travers le transistor d'accès TA1_{F} devient moins importante et en mode lecture la décharge du noeud T est plus fortement compensée par le premier transistor de charge TL1_{T}.

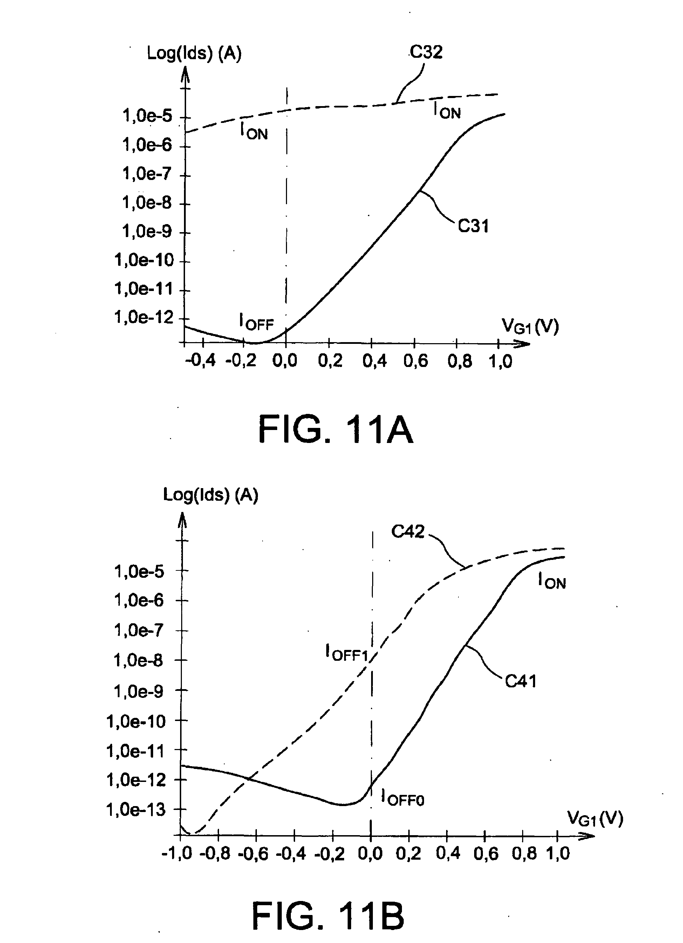

Des caractéristiques électriques d'un transistor double-grille symétrique, sont illustrées sur la figure 11A. Sur cette figure deux courbes de polarisation C31 et C32 sont données. Une première courbe de polarisation C31 est représentative de l'évolution du courant drain-source Ids en fonction d'un potentiel Vg1 appliqué sur une première grille du transistor, lorsque la deuxième grille du transistor se trouve dans un premier état de polarisation et qu'un potentiel Vg2 = 0 Volt est appliqué sur la deuxième grille. Une deuxième courbe de polarisation C32 est représentative de l'évolution du courant drain-source Ids en fonction d'un potentiel Vg1, appliqué sur la première grille du transistor, lorsque la deuxième grille du transistor se trouve dans un troisième état de polarisation et qu'un potentiel Vg2 = VDD, avec VDD un potentiel d'alimentation de la cellule, est appliqué sur la deuxième grille.

Une double-grille asymétrique est formée de deux grilles distinctes dissymétriques par rapport au plan principal de la zone active semi-conductrice de part et d'autre de laquelle ces grilles sont disposées. Dans un transistor doté d'une double-grille asymétrique, le courant délivré entre le drain et la source du transistor est différent suivant que la première grille ou la deuxième grille est activée, même pour une polarisation identique.

La figure 11B donne un exemple de caractéristiques électriques d'un transistor double-grille asymétrique mis en oeuvre dans une cellule mémoire suivant l'invention. Sur cette figure, des courbes C₄₁, C₄₂ sont représentatives, de l'évolution du courant traversant la zone active, entre le drain et la source en fonction d'un potentiel V_{G1} appliqué sur la première grille pour différents valeurs fixes d'un potentiel V_{G2} appliqué sur la deuxième grille. La courbe C₄₁ est donnée pour une première valeur de potentiel V_{G2} qui, dans cet exemple, est de 0 volt, tandis que la courbe C₄₂ est donnée pour une deuxième valeur de potentiel V_{G2} qui, dans cet exemple, est de 1 volt. Dans cet exemple la deuxième grille ne permet pas au transistor de délivrer un courant I_{ON} si elle est activée. Cet exemple de transistor se caractérise par deux courants I_{ON} à l'état passant pour un potentiel appliqué sur la première grille V_{G1} = VDD et un potentiel appliqué sur la deuxième grille V_{G1} tel que V_{G1} = V_{G2} = VDD et deux courants I_{OFF} à l'état bloqué pour V_{G1} = 0V suivant que V_{G2} = 0V ou VDD.

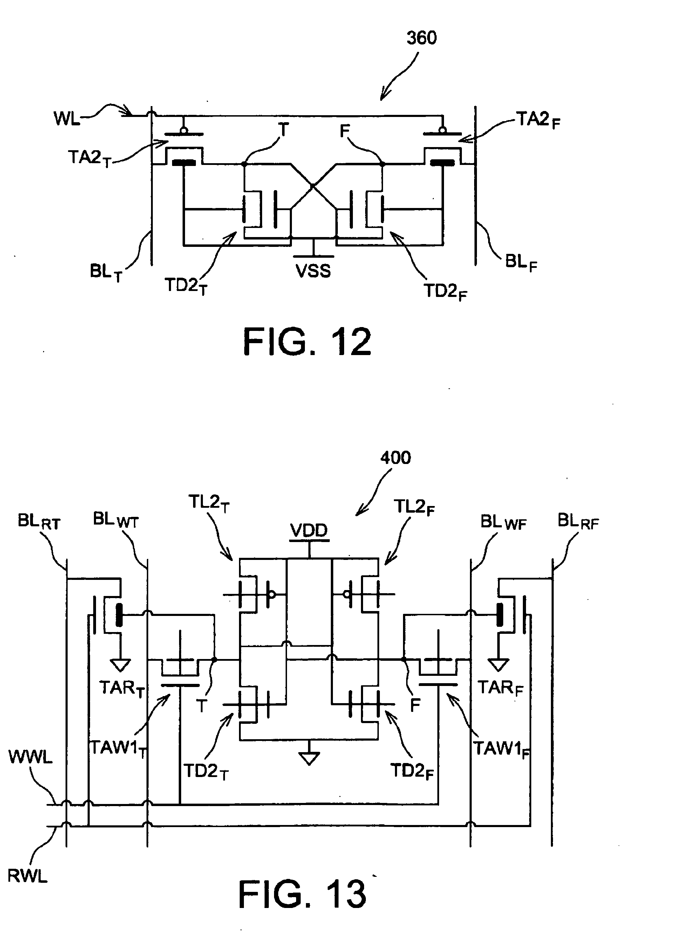

Un quatrième exemple de cellule 360 SRAM à 4 transistors, mise en oeuvre à l'aide d'un procédé suivant l'invention, est illustré sur la figure 12. Ce quatrième exemple de cellule 360, diffère du deuxième exemple en ce que la cellule 360 comprend un premier transistor de conduction TD2_{T} à double-grille cette fois symétrique, ainsi qu'un deuxième transistor de conduction TD2_{F} également à double-grille symétrique.

Des exemples comparatifs des performances de la cellule 300 décrite précédemment, par rapport à celles d'une cellule à 6 transistors mis en oeuvre suivant l'art antérieur, dite « 6T standard », vont à présent être donnés. Ces résultats comparatifs ont été obtenus pour une technologie de 32 nm de dimension critique de grille. Les cellules comparées ont été dimensionnées de telle manière qu'elles présentent approximativement le même courant de lecture ICELL. La cellule 300 permet d'obtenir une marge au bruit statique (SNM) et une marge au bruit en écriture RNM, bien supérieures à la marge au bruit statique de la cellule 6T standard. Comparée à la cellule 6T, la SNM de la cellule 4T est améliorée de plus de 40 % et sa marge en écriture de plus de 50 % pour un gain de surface de l'ordre de 41 %. Les courants de fuite sont également inférieurs de 28 %.

Un autre exemple de cellule mémoire à accès aléatoire, dotée de 8 transistors à double-grille, dont plusieurs transistors à double-grille asymétrique et plusieurs transistors à double-grille symétrique, mis en oeuvre à l'aide d'un procédé suivant l'invention, est donné sur la figure 13.

Cette cellule référencée 400 et dite « 8T », est dotée de quatre transistors d'accès à double grille asymétrique, de deux transistors de charge et de deux transistors de conduction à double-grille symétrique. Le premier transistor d'accès et le deuxième transistor d'accès sont cette fois référencés respectivement TAW1_{T} et TAW1_{F}, tandis que la première ligne de bit, la deuxième ligne de bit, sont référencées respectivement BL_{WT} et BL_{WF}. La cellule 400 comporte une ligne de mot WWL connectée à la première grille du premier et deuxième transistor d'accès TAW1_{T} et TAW1_{F}, et est en outre dotée d'une deuxième ligne de mot RWL, et deux autres lignes de bit BL_{RT} et BL_{RF}. La cellule 400, comporte également un troisième transistor d'accès à double-grille asymétrique TAR1_{T}, et un quatrième transistor d'accès à double-grille asymétrique TAR1_{F}, réalisés, par exemple en technologie NMOS. La première grille du troisième transistor d'accès TAR1_{T} et la première grille du quatrième transistor d'accès TAR1_{F} sont reliées à la deuxième ligne de mot RWL. La seconde grille du troisième transistor d'accès TAR1_{T} est reliée au premier noeud de stockage T, tandis que la seconde grille du quatrième transistor d'accès TAR1_{F} est reliée au deuxième noeud de stockage F. La deuxième ligne de mot RWL, les troisième et quatrième lignes de bits BL_{RT} et BL_{RF} et le troisième et quatrième transistors d'accès TAR1_{T}, TAR1_{F}, sont dédiés aux opérations de lecture de la cellule 400. La première ligne de mot WWL, les lignes de bits BL_{RT}, BL_{RF}, WBLT, WBLF ainsi que le premier transistor d'accès TAW1_{T}, et deuxième transistor d'accès TAW1_{F} sont dédiés aux opérations d'écriture. La cellule 400 comporte également un transistor supplémentaire de conduction TDR1_{T} connecté entre le troisième transistor d'accès et la masse, et un autre transistor supplémentaire TDR1_{F}, connecté entre le quatrième transistor d'accès et la masse.

### Documents cités

[ILL05] : Article de G. Illicali et al, Planar Double Gate Transistors with Asymmetric Independent Gates, SOI Conference (2005). p. 126.
[DEL01]: WO 03/021633A1.
[KED01] : Article de J. Kedziersky et al, High-performance symmetric-gate and CMOS-compatible V, asymmetric-gate FinFET devices, page 19.5.1, IEDM 2001.
[LU05] : Article de CH Lu, Characteritics and Mechanism of Tunable Work Function Gate Electrodes Using a Bilayer Metal Structure on SiO2 and HfO2, EDL vol. 26 (7), p. 445 (2005).
[MAT05] : Article de L. Mathew, Multiple Independent Gate Field Effect Transistor (MIGFET), VLSI 2005, page 200.

## Revendications

1. Procédé de réalisation d'un dispositif microélectronique à un ou plusieurs transistors double-grille asymétrique, comprenant les étapes de :
a) formation sur un substrat (100) d'une ou plusieurs structures (150, 250, 260, 350, 360) comportant respectivement : au moins un premier bloc (110a, 310a), destiné à former une première grille d'une double-grille de transistor, et au moins un deuxième bloc (120a, 320a) situé sur ledit premier bloc et destiné à former la deuxième grille de ladite double-grille, le premier bloc et le deuxième bloc étant disposés de part d'autre d'au moins une zone semi-conductrice (115a) et séparés de la zone semi-conductrice respectivement par une première zone (109a) de diélectrique de grille et une deuxième zone (119a) de diélectrique de grille, les structures (150, 250, 350) étant réalisées de sorte que le premier bloc (110a, 310a) et le deuxième bloc (120a, 320a) ont une dimension critique (dc₀) inférieure à la dimension critique (dc) de la deuxième zone diélectrique et de la première zone diélectrique,
b) dopage d'au moins une ou plusieurs zones semi-conductrices (121a, 122a) du deuxième bloc (120a, 320a) d'au moins une structure (150, 250, 350) donnée parmi lesdites structures, à l'aide d'au moins une étape d'implantation réalisée selon un angle prédéterminé (α) non-nul par rapport à une normale au plan principal du substrat (100) passant par la zone semi-conductrice (115a), la deuxième zone
diélectrique et la première zone diélectrique étant prévues de manière à protéger le premier bloc lors de l'étape d'implantation de sorte
que ladite implantation soit une implantation sélective du deuxième bloc vis-à-vis du premier bloc (110a, 310a).

2. Procédé suivant la revendication 1, dans lequel le premier bloc (110a) est prévu avec une hauteur (h₁) inférieure à la hauteur (h₂) du deuxième bloc (120a).

3. Procédé selon la revendication 2, dans lequel les zones du premier bloc (110a, 310a) situées au voisinage de l'interface avec la première zone diélectrique (109a) ne sont pas implantées.

4. Procédé suivant l'une des revendications 1 à 3, dans lequel à l'étape b), le deuxième bloc (120a) est recouvert d'un masque dur, le masque dur (130) ayant une dimension critique (D) supérieure à la dimension critique (dc) du deuxième bloc (120a).

5. Procédé selon la revendication 4, dans lequel ladite implantation est réalisée dans des zones du deuxième bloc (120a, 320a) situées à proximité et/ou en contact de la deuxième zone diélectrique (119a).

6. Procédé selon l'une des revendications 1 à 5, dans lequel ladite implantation est réalisée d'un premier côté de la structure donnée (150), l'autre côté par rapport à une normale au plan principal du substrat (100) passant par la zone semi-conductrice (115) n'étant pas implanté.

7. Procédé selon l'une des revendications 1 à 6, comprenant après l'étape b) : au moins une étape c) de gravure sélective entre des zones semi-conductrices non-implantées des blocs (110a, 120, 310a, 320a) et des zones semi-conductrices implantées du deuxième bloc (120a, 320a).

8. Procédé selon la revendication 7, dans lequel la gravure sélective est une gravure sélective, entre des zones semi-conductrices non dopées et des zones semi-conductrices dopées (121a, 122a, 321a, 322a) par ladite implantation.

9. Procédé selon la revendication 7, dans lequel la gravure sélective est une gravure sélective, entre des zones semi-conductrices dopées suivant un type de dopage donné et des zones semi-conductrices dopées (121a, 122a, 321a, 322a) par ladite implantation suivant un autre type de dopage différent du type de dopage donné.

10. Procédé suivant l'une des revendications 1 à 9, le premier bloc (110a) et/ou le deuxième bloc (120a) étant semi-conducteurs.

11. Procédé suivant l'une des revendications 1 à 10, le premier bloc (310a) et/ou le deuxième bloc (320a) étant formés respectivement d'au moins une couche métallique (308a, 318a) et d'au moins une couche semi-conductrice (309a, 319a) empilées.

12. Procédé suivant l'une des revendications 1 à 11, ladite structure donnée (150, 250, 350) étant prévue pour un transistor à double-grille asymétrique.

13. Procédé suivant l'une des revendications 1 à 12, dans lequel au moins une structure particulière (260, 360) parmi lesdites structures (250, 350, 260, 360) formées à l'étape a) est protégée de l'étape de dopage réalisée à l'étape b) par l'intermédiaire d'au moins une couche de protection (270), ladite structure particulière (260) étant prévue pour un transistor à double-grille symétrique.

14. Procédé de réalisation d'une cellule mémoire à accès aléatoire dotée de transistors double-grille asymétrique comprenant la mise en oeuvre d'un procédé suivant l'une des revendications 1 à 13.

15. Procédé de réalisation d'une structure de cellule mémoire à accès aléatoire dotée de transistors à double-grille asymétrique et de transistors à double-grille symétrique comprenant la mise en oeuvre d'un procédé suivant l'une des revendications 13 ou 14.

16. Procédé selon l'une des revendications 15, la mémoire étant une mémoire statique à accès aléatoire (SRAM).

## Patentansprüche

1. Verfahren zur Herstellung einer mikroelektronischen Vorrichtung mit einem oder mehreren asymmetrischen Doppelgate-Transistoren, umfassend die Schritte:
a) Bilden einer oder mehrerer Strukturen (150, 250, 260, 350, 360) auf einem Substrat (100), die jeweils umfassen: wenigstens einen ersten Block (110a, 310a), der dazu ausgelegt ist, ein erstes Gate eines Transistor-Doppelgates zu bilden, sowie wenigstens einen zweiten Block (120a, 320a), der auf dem ersten Block angeordnet und dazu ausgelegt ist, das zweite Gate des Doppelgates zu bilden, wobei der erste Block und der zweite Block auf beiden Seiten wenigstens einer Halbleiterzone (115a) angeordnet und von der Halbleiterzone durch eine erste Gatedielektrikumszone (109a) beziehungsweise eine zweite Gatedielektrikumszone (119a) getrennt sind, wobei die Strukturen (150, 250, 350) derart realisiert sind, dass der erste Block (110a, 310a) und der zweite Block (120a, 320a) eine kritische Abmessung (dc₀) aufweisen, die kleiner ist als die kritische Abmessung (dc) der zweiten dielektrischen Zone und der ersten dielektrischen Zone,
b) Dotieren wenigstens einer oder mehrerer Halbleiterzonen (121 a, 122a) des zweiten Blocks (120a, 320a) wenigstens einer gegebenen Struktur (150, 250, 350) aus den Strukturen mit Hilfe wenigstens eines Implantierungsschritts, der entlang eines vorbestimmten Winkels (α) ungleich Null bezogen auf eine Normale zur Hauptebene des Substrats (100) realisiert wird, die durch die Halbleiterzone (115a) verläuft, wobei der vorbestimmte Winkel (α), die zweite dielektrische Zone und die erste dielektrische Zone dazu ausgelegt sind, den ersten Block während des Implantierungsschritts derart zu schützen, dass die Implantierung eine selektive Implantierung des zweiten Blocks bezogen auf den ersten Block (110a, 310a) ist.

2. Verfahren nach Anspruch 1, bei dem der erste Block (110a) mit einer Höhe (h₁) vorgesehen ist, die kleiner ist als die Höhe (h₂) des zweiten Blocks (120a).

3. Verfahren nach Anspruch 2, bei dem keine Implantierung in den Zonen des ersten Blocks (110a, 310a) erfolgt, die in der Nähe der Grenzfläche zur ersten dielektrischen Zone (109a) liegen.

4. Verfahren nach einem der Ansprüche 1 bis 3, bei dem im Schritt b) der zweite Block (120a) mit einer harten Maske bedeckt wird, wobei die harte Maske (130) eine kritische Abmessung (D) hat, die größer ist als die kritische Abmessung (dc) des zweiten Blocks (120a).

5. Verfahren nach Anspruch 4, bei dem die Implantierung in den Zonen des zweiten Blocks (120a, 320a) realisiert wird, die in der Nähe und/oder in Kontakt mit der zweiten dielektrischen Zone (119a) liegen.

6. Verfahren nach einem der Ansprüche 1 bis 5, bei dem die Implantierung auf einer ersten Seite der gegebenen Struktur (150) realisiert wird, wobei auf der anderen Seite bezogen auf eine Normale zur Hauptebene des Substrats (100), die durch die Halbleiterzone (115) verläuft, keine Implantierung erfolgt.

7. Verfahren nach einem der Ansprüche 1 bis 6, umfassend nach dem Schritt b): wenigstens einen Schritt c) des selektiven Gravierens zwischen nichtimplantierten Halbleiterzonen der Blöcke (110a, 120, 310a, 320a) und implantierten Halbleiterzonen des zweiten Blocks (120a, 320a).

8. Verfahren nach Anspruch 7, bei dem das selektive Gravieren ein selektives Gravieren zwischen nicht-dotierten Halbleiterzonen und dotierten Halbleiterzonen (121 a, 122a, 321 a, 322a) mittels der Implantierung ist.

9. Verfahren nach Anspruch 7, bei dem das selektive Gravieren ein selektives Gravieren zwischen Halbleiterzonen ist, die gemäß einem gegebenen Dotiertyp dotiert sind, und Halbleiterzonen (121 a, 122a, 321 a, 322a), die mittels der Implantierung mit einem anderen Dotiertyp dotiert wurden, welcher von dem gegebenen Dotiertyp verschieden ist.

10. Verfahren nach einem der Ansprüche 1 bis 9, wobei der erste Block (110a) und/oder der zweite Block (120a) Halbleiter sind.

11. Verfahren nach einem der Ansprüche 1 bis 10, wobei der erste Block (310a) und/oder der zweite Block (320a) aus wenigstens einer Metallschicht (308a, 318a) beziehungsweise aus wenigstens einer Halbleiterschicht (309a, 319a) in Stapelung gebildet sind.

12. Verfahren nach einem der Ansprüche 1 bis 11, bei dem die gegebene Struktur (150, 250, 350) für einen asymmetrischen Doppelgate-Transistor ausgelegt ist.

13. Verfahren nach einem der Ansprüche 1 bis 12, bei dem wenigstens eine besondere Struktur (260, 360) aus den im Schnitt a) gebildeten Strukturen (250, 350, 260, 360) vor dem im Schritt b) realisierten Dotierschritt geschützt wird mit Hilfe wenigstens einer Schutzschicht (270), wobei die besondere Struktur (260) für einen symmetrischen Doppelgate-Transistor ausgelegt ist.

14. Verfahren zur Herstellung einer Speicherzelle mit wahlfreiem Zugriff, die mit asymmetrischen Doppelgate-Transistoren ausgestattet ist, umfassend die Durchführung eines Verfahrens nach einem der Ansprüche 1 bis 13.

15. Verfahren zur Herstellung einer Speicherzellenstruktur mit wahlfreiem Zugriff, die mit asymmetrischen Doppelgatetransistoren und mit symmetrischen Doppelgatetransistoren ausgestattet ist, umfassend die Durchführung eines Verfahrens nach einem der Ansprüche 13 oder 14.

16. Verfahren nach Anspruch 15, wobei der Speicher ein statischer Speicher mit wahlfreiem Zugriff (SRAM) ist.

## Claims

1. Method for fabricating a microelectronic device with one or several double-gate transistors, comprising the following steps:
a) formation of one or several structures (150, 250, 260, 350, 360) on a substrate (100) comprising at least a first block (110a, 310a), that is intended to form a first gate of a double-gate transistor, and at least a second block (120a, 320a) that is intended to form the second gate of said double-gate, the first block and the second block being located on opposite sides of at least one semiconducting zone (115a) and separated from the semiconducting zone by a first gate dielectric zone (109a) and a second gate dielectric zone (119a) respectively, the first gate dielectric zone (109a) and the second gate dielectric zone (119a), the channel semiconducting zone, and the second block supported on the first block, the structures (150, 250, 350) being made such that the first block (110a, 310a) and the second block (120a, 320a) have a critical dimension (dc₀) less than the critical dimension (dc) of the second isolating zone and the first isolating zone,
b) doping of at least one or several semiconducting zones (121a, 122a) in the second block (120a, 320a) of at least one given structure (150, 250, 350) among said structures, , said first implantation being done at a non zero predetermined angle (α) from a normal to the principal plane of the substrate (100) passing through the semiconducting zone (115a), the first dielectric zone and the second dielectric zone being designed to protect at least part of the first block during the implantation step, so that said implantation step is selective relative to the first block (110a, 310a).

2. Method according to claim 1, wherein the first block (110a) has an height (h₁) lower than the height (h₂) of the second block (110b).

3. Method according to claim 2, in which zones of the first block (110a, 310a) located close to the first dielectric zone (109a) are not implanted.

4. Method according to any of claims 1 to 3, in which the second block (120a) is covered by a hard mask in step b), the critical dimension (D) of the hard mask (130) being larger than the critical dimension (dc) of the second block (120a).

5. Method according to claim 4, in which said implantation is done in zones in the second block (120a, 320a) located close to and/or in contact with the second dielectric zone (119a).

6. Method according to one of claims 1 to 5, in which said implantation is done on a first side of the given structure (150), the part of the structure on the other side of a normal to the principal plane of the substrate (100) passing through the semiconducting zone (115) not being implanted.

7. Method according to one of claims 1 to 6, comprising at least one selective etching step c) between non-implanted semiconducting zones of blocks (110a, 120, 310a, 320a) and implanted semiconducting zones of the second block (120a, 320a) after step b).

8. Method according to claim 7, in which selective etching is selective between non-doped semiconducting zones and semiconducting zones doped (121a, 122a, 321a, 322a) using said implantation.

9. Method according to claim 7, in which selective etching is selective between semiconducting zones doped using a given type of doping and semiconducting zones doped (121a, 122a, 321a, 322a) by said implantation using another type of doping different from the given type of doping.

10. Method according to one of claims 1 to 9, the first block (110a) and/or the second block (120a) being semiconductors.

11. Method according to one of claims 1 to 10, the first block (310a) and/or the second block (320a) being formed from at least one metallic layer (308a, 318a) and at least one stacked semiconducting layer (309a, 319a) respectively.

12. Method according to one of claims 1 to 11, said given structure (150, 250, 350) being designed for an asymmetric double-gate transistor.

13. Method according to one of claims 1 to 12, in which at least one particular structure (260, 360) among said structures (250, 350, 260, 360) formed in step a) is protected during the doping step done in step b), by means of at least one protection layer (270), said particular structure (260) being designed for a symmetric double-gate transistor.

14. Method for fabricating a random access memory cell provided with asymmetric double-gate transistors using a method according to one of claims 1 to 13.

15. Method for fabricating a random access memory cell structure provided with asymmetric double-gate transistors and symmetric double-gate transistors using a method according to one of claims 13 or 14.

16. Method according to claim 15, the memory being a static random access memory (SRAM).
